# EUROPÄISCHE PATENTSCHRIFT

(11) **EP 1 618 430 B1**
(45) Veröffentlichungstag und Bekanntmachung des Hinweises auf die Patenterteilung: **10.01.2018**
(21) Anmeldenummer: 04727511.0
(22) Anmeldetag: 15.04.2004
(51) Int. Cl.: G03B 21/20, H01L 33/58, H04N 9/31

(54) **LICHTQUELLE**
LIGHT SOURCE
SOURCE LUMINEUSE

(30) Priorität: 29.04.2003 DE 10319274
(43) Veröffentlichungstag der Anmeldung: 25.01.2006
(73) Patentinhaber: OSRAM Opto Semiconductors GmbH, 93055 Regensburg (DE)
(72) Erfinder: BOGNER, Georg, 93138 Lappersdorf (DE); GRÖTSCH, Stefan, 93077 Bad Abbach (DE)
(74) Vertreter: Epping - Hermann - Fischer
(86) Internationale Anmeldenummer: PCT/DE2004/000800
(87) Internationale Veröffentlichungsnummer: WO 2004/097946

(56) Entgegenhaltungen:
- EP-A- 0 322 106
- EP-A- 0 869 388
- EP-A- 0 985 952
- EP-A- 1 003 062
- EP-A- 1 098 535
- WO-A-98/20475
- JP-A- 8 103 167
- US-A- 4 951 179
- US-A- 5 604 607
- US-A- 5 727 108
- US-A1- 2002 030 194
- US-B1- 6 252 155

## Beschreibung

Die Erfindung betrifft eine Lichtquelle mit einer Vielzahl von Halbleiterchips und einer Vielzahl von Primäroptikelementen. Es sind mindestens zwei, bevorzugt drei verschiedene, elektromagnetische Strahlung emittierende Chipsorten mit unterschiedlichen Emissionsspektren enthalten, wobei jeder Halbleiterchip eine Chipauskoppelfläche aufweist, durch die Strahlung ausgekoppelt wird. Jedem Halbleiterchip ist ein Primäroptikelement zugeordnet, das einen Lichteingang und einen Lichtausgang aufweist und durch das die Divergenz zumindest eines Teils der von dem Halbleiterchip bei dessen Betrieb emittierten Strahlung verringert wird. Die Anmeldung betrifft insbesondere derartige Lichtquellen, bei denen die Halbleiterchips sichtbare elektromagnetische Strahlung emittieren.

Die meisten bekannten Lichtquellen weisen Glühlampen, Bogenlampen oder Hochdrucklampen auf. Bei deren Betrieb wird ein relativ großer Anteil von elektrischer Energie in Wärme umgewandelt, was für umgebende Bauteile oder Bauelemente problematisch sein kann. Zur Erzeugung von Licht eines bestimmten Farbortes auf der CIE-Farbtafel werden hierbei in der Regel optische Filter verwendet, um unerwünschte Farbanteile weitestgehend zu beseitigen. Hierdurch wird jedoch die Effizienz der jeweiligen Lichtquelle reduziert.

Alternativ gibt es Lichtquellen, bei denen Leuchtdioden (LEDs) verwendet werden, die beispielsweise den Vorteil einer langen Lebensdauer, eines schnellen Ansprechens sowie eines relativ hohen elektrischen Wirkungsgrades haben. Zudem lässt sich durch Kombination von LEDs unterschiedlicher Farben mischfarbiges Licht eines bestimmten Farbortes erzeugen. Farbfilter sind hierbei nicht unbedingt erforderlich.

Eine Lichtquelle zur Hinterleuchtung eines LCD-Displays, die LEDs unterschiedlicher Emissionsspektren aufweist, ist beispielsweise in der US 6,540,377 beschrieben. Bei dieser sind rot-, grün- sowie blauemittierende LEDs miteinander durchmischt auf einer gemeinsamen Ebene angeordnet. Die elektromagnetische Strahlung der LEDs wird bei Betrieb der Lichtquelle in einem gemeinsamen Lichtkegel abgestrahlt und mittels Diffusormaterial durchmischt.

Ein Nachteil einer derartigen Lichtquelle ist, dass die von ihr pro Raumwinkel abgestrahlte Lichtintensität durch die maximale Emissionsintensität der LEDs begrenzt ist, wodurch ihre Anwendbarkeit beschränkt ist. Zudem muss für eine ausreichende Durchmischung der von unterschiedlichen LEDs emittierten elektromagnetischen Strahlung gesorgt werden, wenn homogenes Licht erwünscht ist.

EP 0 985 952 A beschreibt eine Anzeigevorrichtung, welche für jede Gruppe von Halbleiterchips ein LCD-Panel umfasst, wobei den unterschiedlichen Gruppen unterschiedliche LCD-Panele für Licht unterschiedlicher Farben nachgeordnet sind. Ferner kommen bei der Anzeigevorrichtung sogenannte X-Cubes zum Einsatz. Der X-Cube weist eine Lichteintrittsseite für rotes Licht, eine Lichteintrittsseite für grünes Licht und eine Lichteintrittsseite für blaues Licht auf.

Aufgabe der vorliegenden Erfindung ist insbesondere, eine Lichtquelle auf der Basis von sichtbare elektromagnetische Strahlung emittierenden Halbleiterchips zu entwickeln, die eine hohe pro Raumwinkel abgestrahlte Lichtintensität aufweist, welche nicht durch die maximale Emissionsintensität der Halbleiterchips begrenzt ist. Die Aufgabe der Erfindung umfasst auch, dass bei der Lichtquelle elektromagnetische Strahlung von Halbleiterchips mit unterschiedlichen Emissionsspektren einfach und effektiv miteinander durchmischt werden kann.

Diese Aufgaben werden durch eine Lichtquelle mit den Merkmalen des Patentanspruches 1 gelöst.

Vorteilhafte Ausführungsformen und bevorzugte Weiterbildungen der Lichtquelle sind in den abhängigen Patentansprüchen angegeben.

Es wird eine Lichtquelle der eingangs genannten Art angegeben, bei der die Halbleiterchips mit den Primäroptikelementen in mindestens zwei örtlich voneinander getrennten Gruppen angeordnet sind, so dass die Gruppen bei Betrieb der Halbleiterchips separate Lichtkegel aussenden. Die separaten Lichtkegel der Gruppen werden mittels einer Sekundäroptik zu einem einzigen gemeinsamen Lichtkegel überlagert.

Mit Lichtkegel ist hierbei sowie im Folgenden jeweils ein beliebig geformtes Volumen gemeint, das durch Licht der Lichtquelle durchleuchtet ist, wobei Bereiche ausgeschlossen sind, in denen die Helligkeit mehr als eine Größenordnung geringer ist als die maximale Helligkeit bei gleichem Abstand zur Lichtquelle.

Durch die Überlagerung separater Lichtkegel verschiedener Gruppen von Halbleiterchips erreicht man eine additive Durchmischung von Strahlung unterschiedlicher Halbleiterchips. Dadurch kann eine verbesserte Mischung der Strahlung von Halbleiterchips mit unterschiedlichen Emissionsspektren technisch einfach erreicht werden. Desweiteren kann die pro Raumwinkel abgestrahlte Lichtintensität durch die Überlagerung separater Lichtkegel unabhängig von der maximalen Lichtintensität einzelner Halbleiterchips deutlich erhöht werden.
In einer bevorzugten Ausführungsform werden die separaten Lichtkegel der Gruppen mittels der Sekundäroptik zu einem gemeinsamen Lichtkegel mit einem weitestgehend einheitlichen Farbort überlagert. Mit besonderem Vorteil liegt dabei der Farbort des gemeinsamen Lichtkegels im Weißbereich der CIE-Farbtafel. Erfindungsgemäß weist mindestens eine der Gruppen Halbleiterchips von nur einer Chipsorte auf.

Die Vielzahl von Halbleiterchips weist eine erste, eine zweite und eine dritte Chipsorte auf, deren Emissionsspektren derart ausgewählt sind, dass sich durch Überlagerung der von Halbleiterchips unterschiedlicher Chipsorten emittierten Strahlung weißes Licht erzeugen lässt.
Besonders bevorzugt emittiert hierbei die erste Chipsorte grüne Strahlung, die zweite Chipsorte rote Strahlung und die dritte Chipsorte blaue Strahlung, d.h. das jeweilige Emissionsspektrum von Halbleiterchips einer Chipsorte weist Strahlung auf, deren Wellenlängen in erster Linie im grünen, roten beziehungsweise blauen Bereich liegt.

Die Halbleiterchips der ersten Chipsorte sind in einer ersten Gruppe und die Halbleiterchips der zweiten und dritten Chipsorte in einer zweiten Gruppe angeordnet, wobei die Halbleiterchips unterschiedlicher Chipsorten der zweiten Gruppe miteinander durchmischt angeordnet sind. Die Halbleiterchips unterschiedlicher Chipsorten der zweiten Gruppe sind bevorzugt gleichmäßig miteinander durchmischt angeordnet.

Die Sekundäroptik, mittels der die separaten Lichtkegel überlagert werden, weist bevorzugt mindestens eine selektiv reflektierende Einheit auf. Diese ist für die Strahlung mindestens eines separaten Lichtkegels durchlässig und für die Strahlung eines weiteren separaten Lichtkegels reflektierend. Mittels der selektiv reflektierenden Einheit werden mindestens zwei separate Lichtkegel überlagert.
Besonders bevorzugt enthält die selektiv reflektierende Einheit ein dichroitisches Schichtsystem.
In einer vorteilhaften Ausführungsform weist die Sekundäroptik mindestens einen Zusammenblendwürfel auf, der auf mindestens einer selektiv reflektierenden Einheit basiert. Der Zusammenblendwürfel weist mindestens zwei Lichteingänge auf, in die jeweils ein Lichtkegel einfällt. Die in den Zusammenblendwürfel eingestrahlten Lichtkegel werden im Inneren von diesem mittels der selektiv reflektierenden Einheit überlagert und gemeinsam aus einem Lichtausgang des Zusammenblendwürfels emittiert. Der einfallende Lichtkegel kann jeweils ein ursprünglicher unmittelbar von einer Gruppe von Halbleiterchips stammender separater Lichtkegel oder ein Lichtkegel sein, in dem bereits mehrere solche separaten Lichtkegel überlagert sind.

Mit besonderem Vorteil ist der Öffnungswinkel eines separaten Lichtkegels zwischen 0 und 60°, bevorzugt zwischen 0 und 40°, besonders bevorzugt zwischen 0 und 20° groß, wobei die Grenzen jeweils einbezogen sind. Wie oben dargelegt bezieht sich der Ausdruck Lichtkegel in diesem Zusammenhang nicht auf die Form eines Kegels im mathematischen Sinne und kann demnach mehr als einen Öffnungswinkel aufweisen. Ist das der Fall, so bezieht sich die obige Aussage auf den maximalen Öffnungswinkel.

Dadurch, dass die Divergenz der separaten Lichtkegel durch die Primäroptikelemente auf ein derartiges Maß begrenzt ist, lässt sich eine höhere Leuchtdichte bzw. pro Raumwinkel abgestrahlte Lichtintensität der Lichtquelle erreichen.

Insbesondere um einen derart geringen Öffnungswinkel eines vom Primäroptikelement emittierten Lichtkegels zu realisieren, weist der Lichtausgang des Primäroptikelements mit besonderem Vorteil eine Lichteingangsfläche oder eine Lichteingangsöffnung auf, deren Größe kleiner als oder gleich der zweifachen Chipauskoppelfläche ist. Besonders bevorzugt ist die Größe der Lichteingangsfläche oder der Lichteingangsöffnung maximal 1,5 mal so groß, insbesondere maximal 1,1 mal oder 1,05 mal so groß wie die Chipauskoppelfläche.

Die Größe der Lichteingangsfläche oder der Lichteingangsöffnung ist bevorzugt größer oder nicht wesentlich kleiner als die Chipauskoppelfläche.

Der so beschaffene Lichteingang des Primäroptikelements eignet sich nicht nur für eine starke Verringerung der Divergenz eines Lichtkegels, sondern ermöglicht auch eine signifikante Miniaturisierung des Primäroptikelements und somit eine Herstellung einer kompakten Lichtquelle mit einer hohen emittierten Lichtdichte.

Bevorzugt sind die Primäroptikelemente mindestens einer Gruppe zumindest teilweise derart angeordnet, dass ihre Lichtausgänge dicht gepackt sind. Bevorzugt schließen sie lückenlos aneinander an. Dadurch lässt sich eine höhere Leuchtdichte und eine bessere Homogenität eines separaten Lichtkegels und somit auch des gemeinsamen Lichtkegels erreichen.

In einer vorteilhaften Ausführungsform sind die Halbleiterchips sämtlicher Gruppen im wesentlichen in einer gemeinsamen Ebene angeordnet. Dies kann eine Montage der Halbleiterchips vorteilhafterweise signifikant vereinfachen.

Mit Vorteil sind die Halbleiterchips mit den Primäroptikelementen zumindest teilweise oder zumindest in Teilgruppen matrixartig, d.h. regelmäßig in Zeilen und Spalten angeordnet.

Bei einer bevorzugten Ausführungsform der Lichtquelle ist das Primäroptikelement jeweils ein optischer Konzentrator, der zur Lichtquelle derart angeordnet ist, dass sein eigentlicher Konzentratorausgang nunmehr der Lichteingang ist. Verglichen mit der üblichen Anwendung eines Konzentrators (auf die sich der oben verwendete Begriff "eingentlicher" Konzentratorausgang bezieht) läuft vorliegend Licht der Halbleiterchips in umgekehrter Richtung durch den Konzentrator. Somit wird dieses Licht nicht konzentriert, sondern verläßt den Konzentrator mit verringerter Divergenz durch den nunmehr als Lichtausgang verwendeten eigentlichen Lichteingang. Das "eigentlich" bezieht sich wiederum auf die tatsächliche Nutzung als Konzentrator.

Besonders bevorzugt ist der Konzentrator ein CPC-, CEC- oder CHC-artiger Konzentrator, womit hierbei sowie im Folgenden ein Konzentrator gemeint ist, dessen reflektierende Seitenwände zumindest teilweise und/oder zumindest weitestgehend die Form eines zusammengesetzten parabolischen Konzentrators (compound parabolic concentrator, CPC), eines zusammengesetzten elliptischen Konzentrators (compound elliptic concentrator, CEC) und/oder eines zusammengesetzten hyperbolischen Konzentrators (compound hyperbolic concentrator, CHC) aufweisen. Derart gestaltete Primäroptikelemente ermöglichen eine effiziente Verringerung der Divergenz von Licht, wodurch sich die pro Raumwinkel abgestrahlte Lichtintensität vergrößern lässt.

Als Alternative zu dem CPC-, CEC- oder CHC-artigen Konzentrator weist der Konzentrator bevorzugt den Lichteingang mit dem Lichtausgang verbindende Seitenwände auf, entlang denen direkte Verbindungslinien zwischen dem Lichteingang und dem Lichtausgang im wesentlichen gerade verlaufen. Die Seitenwände weisen mit Vorteil statt paraboloid-, ellipsoid- oder hyperboloid-artig gekrümmten Seitenwänden im wesentlichen gerade verlaufende Seitenwände auf, so dass das Primäroptikelement beispielsweise eine Grundform eines Pyramidenstumpfes oder eines Kegelstumpfes aufweist.

Der Konzentrator weist in einem Bereich auf der Seite des Lichteingangs bevorzugt eine Querschnittsfläche in Form eines regelmäßigen Vielecks, besonders bevorzugt eine quadratische Querschnittsfläche auf. In einem Bereich auf der Seite des Lichtausgangs weist er bevorzugt ebenfalls eine Querschnittsfläche in Form eines regelmäßigen Vielecks, besonders bevorzugt eine drei-, vier-, sechs- oder achteckige Querschnittsfläche auf. Zwischen diesen Bereichen geht die Querschnittsfläche von der einen in die andere Form über. Der Lichteingang des Konzentrators lässt sich somit an die übliche Form von Halbleiterchips anpassen und der Lichtausgang lässt sich beispielsweise derart gestalten, dass sich die Lichtausgänge mehrerer Primäroptikelemente regelmäßig zueinander und lückenlos anordnen lassen. Die Verwendung derartiger Primäroptikelelemente ermöglicht es, die Halbleiterchips mit relativ großem Abstand voneinander anzuordnen, ohne dass der von dieser Anordnung abgestrahlte Lichtkegel lückenhaft ausgeleuchtet erscheint. Durch den Anbstand zwischen den Halbleiterchips lässt sich die von ihnen erzeugte Wärme besser abführen.

In einer vorteilhaften Ausführungsform weist der Konzentrator einen einen Hohlraum definierenden Grundkörper auf, dessen Innenwand für ein von dem zugeordneten Halbleiterchip ausgesandtes Licht reflektierend ist und/oder dessen Innenwand im Wesentlichen mit einer Schicht oder Schichtenfolge, bevorzugt mit einer metallischen Schicht versehen ist, die für ein von dem zugeordneten Halbleiterchip ausgesandtes Licht reflektierend ist.

Alternativ ist der Konzentrator mit Vorteil ein dielektrischer Konzentrator, dessen Grundkörper ein aus einem dielektrischen Material mit geeignetem Brechungsindex bestehender Vollkörper ist, so dass über den Lichteingang eingekoppeltes Licht in diesem durch Totalreflexion an der den Lichteingang mit dem Lichtausgang verbindenden seitlichen Grenzfläche des Vollkörpers zum umgebenden Medium reflektiert wird. Dies hat den Vorteil, dass es aufgrund von Reflexionen im Konzentrator weitestgehend keine Lichtverluste gibt.

Mit besonderem Vorteil weist der dielektrische Konzentrator als Lichtausgang eine linsenartig gewölbte Grenzfläche auf, die z.B. sphärisch oder asphärisch gewölbt sein kann. Dadurch kann eine weitere Verringerung der Divergenz eines Lichtkegels erzielt werden. Der Lichtausgang ist bevorzugt in der Art einer asphärischen Linse gewölbt, wodurch etwa der Größe der Chipauskoppelfläche Rechnung getragen werden kann. Sphärische Linsen sind für punktförmige Lichtquellen optimal und können bei nichtpunktförmigen Lichtquellen signifikant schlechtere Eigenschaften hinsichtlich einer Verringerung der Divergenz eines Lichtkegels aufweisen.

Bei einer weiteren Ausführungsform ist der dielektrische Konzentrator mit Vorteil zumindest teilweise mit einer Schicht oder Schichtenfolge, bevorzugt mit einer metallischen Schicht versehen, die für von dem jeweiligen Halbleiterchip ausgesandtes Licht reflektierend ist. Dies kann z.B. vorteilhaft sein, wenn der Halbleiterchip in dem Material des Konzentrators eingebunden ist, um zu verhindern, dass die Strahlung, die in einem ersten Teil des Konzentrators die Bedingung der Totalreflexion nicht erfüllt, seitlich aus dem Konzentrator ausgekoppelt wird.

Bevorzugt ist der Konzentrator dem Halbleiterchip in dessen Hauptabstrahlrichtung nachgeordnet und besteht zwischen der Chipauskoppelfläche und dem Lichteingang des Konzentrators ein Spalt. Dieser ist mit Vorteil weitestgehend frei von fester oder viskoser Materie.

Dadurch wird erreicht, dass insbesondere Strahlen, die in besonders großem Winkel gegenüber der Hauptabstrahlrichtung eines Halbleiterchips emittiert werden und die einen separaten Lichtkegel zu stark aufweiten würden, nicht auf den Lichteingang treffen, sondern seitlich an diesem vorbeilaufen und erst gar nicht in den Konzentrator eingekoppelt werden. Im Falle eines dielektrischen Konzentrators führt der Spalt dazu, dass von den Strahlen ein umso größerer Anteil an der Grenzfläche des Lichteingangs reflektiert wird, je größer deren Einfallswinkel auf den Lichteingang ist. Somit wird jeweils der hochdivergente Anteil des in den Konzentrator gelangenden Lichts abgeschwächt.

Insbesondere in diesem Zusmmenhang ist es besonders vorteilhaft, wenn dem Primäroptikelement ein oder mehrere Reflektorelemente zugeordnet sind, die derart angeordnet und/oder von solcher Form sind, dass ein Teil der Lichtstrahlen, die nicht direkt vom Halbleiterchip in den Konzentrator gelangen, an diesen mehrfach reflektiert werden und mit einem geringeren Winkel zur Hauptabstrahlrichtung des Halbleiterchips auf den Lichteingang des Konzentrators gelenkt werden. Dies führt zur Erhöhung der Intensität des in den Konzentrator gelangenden Lichts.

Zweckmäßigerweise besteht der Grundkörper des Konzentrators aus einem transparenten Glas, einem transparenten Kristall oder einem transparenten Kunststoff. In letzterem Fall ist der Konzentrator bevorzugt in einem Spritzpress- und/oder einem Spritzgußverfahren gefertigt.

Besonders bevorzugt ist das Material des Grundkörpers gegenüber einer von dem Halbleiterchip ausgesandten Strahlung, insbesondere gegenüber einer elektromagnetischen Strahlung aus dem blauen oder UV Spektralbereich resistent. Das Material weist hierfür z.B. Silikon auf oder besteht aus diesem.

Der Halbleiterchip ist in einer vorteilhaften Ausführungsform eine elektromagnetische Strahlung emittierende Diode, bevorzugt eine elektromagnetische Strahlung emittierende Diode mit zumindest näherungsweise lambertscher Abstrahlcharakteristik, besonders bevorzugt ein Dünnfilm-Leuchtdioden-Chip.

Ein Dünnfilm-Leuchtdioden-Chip zeichnet sich insbesondere durch folgende charakteristische Merkmale aus:
- an einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20*µ*m oder weniger, insbesondere im Bereich von 10 *µ*m auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Ein Dünnfilm-Leuchtdiodenchip ist in guter Näherung ein Lambert'scher Oberflächenstrahler und eignet sich von daher besonders gut für die Anwendung in einer gerichteten Lichtquelle.

Bei einer bevorzugten Ausführungsform der Lichtquelle sind die Halbleiterchips auf je einem Träger angeordnet, auf dem sie jeweils von einem Rahmen umgeben sind. An oder in dem Rahmen ist das Primäroptikelement angebracht. Es wird von diesem gehalten und/oder ist durch diesen relativ zur Chipauskoppelfläche justiert.

Zumindest Teile bzw. ein Teil der Träger und/oder jeweils der Träger und der Rahmen sind vorteilhafterweise miteinander einteilig ausgebildet.

In einer weiteren Ausführungsform der Lichtquelle ist bzw. sind die Innenfläche des Rahmens und/oder freie Flächen der zur Abstrahlrichtung des Halbleiterchips gewandten Oberfläche des Trägers für von der jeweiligen Halbleiterchip ausgesandten Strahlung reflektierend. Zusätzlich oder alternativ ist bzw. sind diese zumindest teilweise mit einer Schicht oder Schichtenfolge, bevorzugt mit einer metallischen Schicht versehen, die für von dem jeweiligen Halbleiterchip ausgesandte Strahlung reflektierend ist.

Mit besonderem Vorteil sind mehrere Primäroptikelemente einteilig miteinander ausgebildet. Dies kann sowohl eine Herstellung der Primäroptikelemente als auch eine Montage von diesen in einer Lichtquelle signifikant vereinfachen, was beispielsweise zu geringeren Herstellungskosten führen kann.

Weitere Vorteile, bevorzugte Ausführungsformen und Weiterbildungen der Lichtquelle ergeben sich aus den im folgenden in Verbindung mit den Figuren 1 bis 7 erläuterten Ausführungsbeispielen. Es zeigen:
Figur 1 eine schematische Darstellung eines Schnittes durch einen Halbleiterchip mit Primäroptikelement einer Lichtquelle gemäß der Erfindung,
Figur 2 eine schematische perspektivische Darstellung einer Anordnung mit Halbleiterchip und Primäroptikelement einer weiteren Lichtquelle gemäß der Erfindung,
Figur 3a eine schematische perspektivische Darstellung einer Anordnung mit Halbleiterchip und Primäroptikelement einer nochmals weiteren Lichtquelle gemäß der Erfindung,
Figur 3b eine schematische perspektivische Darstellung eines Schnittes durch die Anordnung mit Halbleiterchip und Primäroptikelement aus Figur 3a, der zusätzlich ein Rahmen zugeordnet ist,
Figuren 4a bis 4c schematische Darstellungen von Draufsichten verschiedener Lichtquellen, die jedoch keine Ausführungsformen der vorliegend beanspruchten Lichtquelle darstellen,
Figuren 5a und 5b schematische Darstellungen von Draufsichten von zwei Ausführungsbeispielen der Lichtquelle,
Figur 6 eine schematische dreidimensionale Ansicht eines weiteren Ausführungsbeispiels eines Primäroptikelementes, und
Figur 7 eine schematische dreidimensionale Ansicht eines Ausführungsbeispiels von einteilig miteinander ausgebildeten Primäroptikelementen.

In den Ausführungsbeispielen und Figuren sind gleiche oder gleichwirkende Bestandteile jeweils mit den gleichen Bezugszeichen versehen.

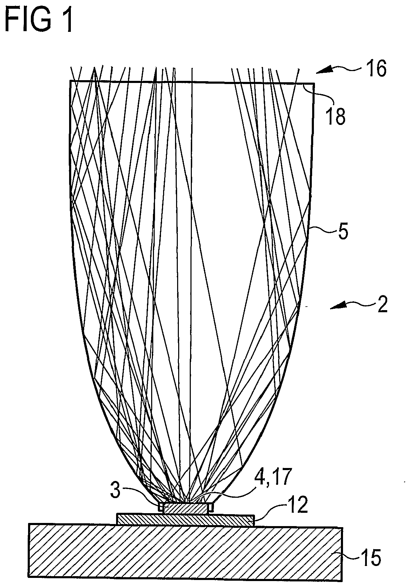

Bei der in Figur 1 gezeigten Anordnung mit Halbleiterchip 3 und Primäroptikelement 5, im Folgenden kurz Chip-PrimäroptikElement 2 genannt, ist ein Halbleiterchip 3 auf einem ersten Träger 12 aufgebracht. Das Primäroptikelement 5 ist dem Halbleiterchip 3 in dessen Hauptabstrahlrichtung nachgeordnet. Der erste Träger 12 ist wiederum auf einem zweiten Träger 15 aufgebracht, der als eine Wärmesenke für die vom Halbleiterchip 3 bei dessen Betrieb erzeugte Wärme dient.

Der erste Träger 12 ist beispielsweise eine Leiterplatte (PCB), deren möglicher Aufbau und mögliche Materialien dem Fachmann bekannt sind und deshalb an dieser Stelle nicht näher erläutert werden. Der zweite Träger 15 besteht beispielsweise aus Kupfer.

Der Halbleiterchip 3 ist z.B. ein Dünnfilm-Leuchtdiodenchip, der wie im allgemeinen Teil beschrieben beschaffen sein kann. Darüber hinaus kann die Epitaxieschichtenfolge auf mindestens einem Material des Systems InₓAl_{y}Ga_{1-x-y}N oder InₓGa_{y}Al_{1-x-y}P mit 0 ≤ x ≤ 1, 0 ≤ y ≤ 1 und x+y ≤ 1 basieren. Er weist eine Chipauskoppelfläche 4 auf, die direkt an den Lichteingang 17 des Primäroptikelements 5 anschließt.

Das Primäroptikelement 5 ist ein dreidimensionaler, CPC-artiger Konzentrator, dessen Lichteingang 17 und Lichtausgang 18 kreisförmig sind. Durch den Lichteingang 17 tritt Licht, in Form von sichtbarer elektromagnetischer Strahlung vom Halbleiterchip 3 aus in das Primäroptikelement 5 ein. Die Strahlung wird an den den Lichteingang 17 mit dem Lichtausgang 18 verbindenden Wänden derart reflektiert, dass die Divergenz des Lichts deutlich verringert wird (angedeutet durch die Linien 16). Der aus dem Lichtausgang 18 abgestrahlte Lichtkegel hat beispielsweise einen Öffnungswinkel von unter 20°, z.B. etwa 9°, wohingegen der Halbleiterchip näherungsweise eine lambert'sche Abstrahlcharakteristik aufweist.

Der Grundkörper des Primäroptikelements 5 fungiert wie ein Hohlkörper, dessen Innenwand mit einem für ein von dem Halbleiterchip ausgesandtes Licht reflektierenden Material versehen ist. Dies kann beispielsweise eine metallische Schicht sein, die etwa aus Al besteht. Das Material, aus dem der Grundkörper im Wesentlichen gefertigt ist, kann ein Kunststoff wie etwa Polycarbonat sein, beispielsweise kann der Grundkörper mittels Spritzgießen aus einem solchen hergestellt sein.

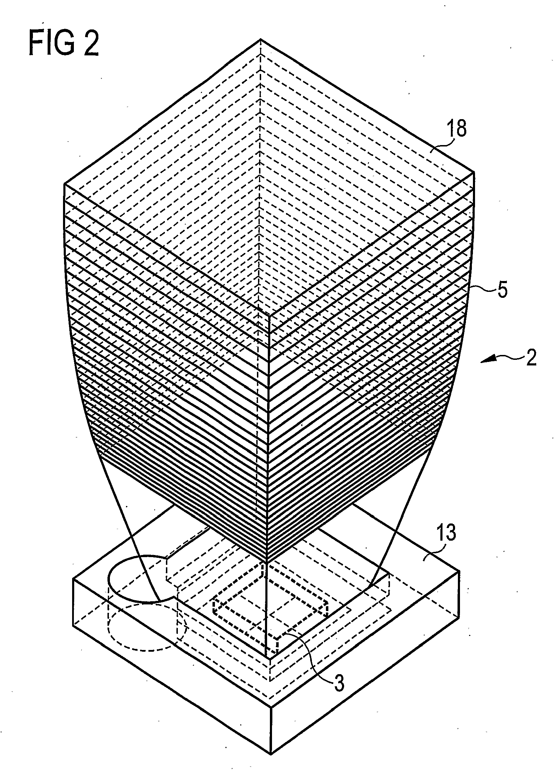

Wie in Figur 2 gezeigt, kann der Halbleiterchip 3 zusätzlich von einem Rahmen 13 umgeben sein, durch den das Primäroptikelement 5 gehalten und/oder relativ zu dem Halbleiterchip 3 justiert sein kann. Der Rahmen ist z.B. teilweise mit einer Vergußmasse gefüllt.

Bei der in Figur 2 gezeigten Anordnung mit Halbleiterchip 3 und Primäroptikelement 5 weist der CPC-artige Konzentrator im Unterschied zu dem anhand Figur 1 erläuterten Beispiel senkrecht zu dessen Hauptabstrahlrichtung einen Querschnitt mit einer quadratische Form auf, so dass insbesondere auch dessen Lichteingang (nicht gezeigt) und Lichtausgang 18 quadratisch sind. Somit ist die Form des Primäroptikelements 5 an die Form der Chipauskoppelfläche des Halbleiterchips 3 angepasst. Dies hat zudem insbesondere den Vorteil, dass sich die Lichtausgänge mehrerer derartiger Elemente 2 lückenlos in einer beliebig großen Fläche anordnen lassen.

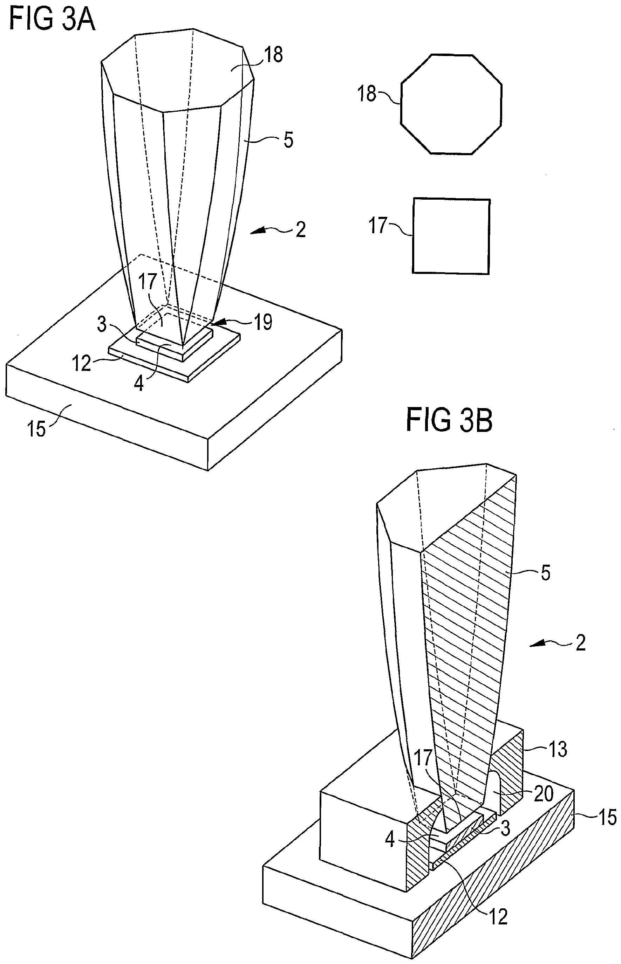

Bei der Anordnung gemäß den Figuren 3a und 3b ist das Primäroptikelement 5 ein dielektrischer CPC-artiger Konzentrator, dessen Grundkörper beispielsweise aus einem transparenten Kunststoff, beispielsweise Polycarbonat besteht.

Der Lichteingang 17 weist eine quadratische Form auf, während der Lichtausgang 18 die Form eines regelmäßigen Achtecks aufweist (rechts neben dem Primäroptikelement 5 jeweils in Draufsicht gezeigt). Dazwischen geht die Querschnittsform des Primäroptikelements 5 von der quadratischen in die achteckige Form über.

Zwischen der Chipauskoppelfläche 4 des Halbleiterchips 3 und dem Lichteingang 17 besteht ein Luftspalt 19. Dadurch wird gemäß der weiter oben im allgemeinen Teil der Beschreibung bereits dargelegten Wirkungsweise der hochdivergente Anteil des in das Primäroptikelement 5 gelangenden Lichts geschwächt.

In Figur 3b ist ergänzend zu Figur 3a ein Rahmen 13 des Chip-Primäroptik-Elements 2 gezeigt. Die Innenwand 20 dieses Rahmens 13 sowie die Vorderseite des ersten Trägers 12 sind reflektierend ausgebildet, so dass zumindest ein Teil der Strahlung, die nicht direkt in das Primäroptikelement 5 gelangt, an diesen derart mehrfach reflektiert wird, dass sie dann mit einem geringeren Winkel zur Achse des Primäroptikelements 5 auf dessen Lichteingang 17 gelenkt wird. Der Rahmen 13 kann hierbei einteilig mit dem ersten Träger 12 ausgebildet sein, was natürlich eine mehrteilige Ausführung eventuell mit Bestandteilen aus unterschiedlichen Materialien nicht ausschließt.

Alternativ kann der Halbleiterchip 3 auch in dem Material des Primäroptikelements 5 eingebettet sein oder kann dessen Chipauskoppelfläche mit dem Lichteingang 17 physikalischen Kontakt haben.

Zumindest ein Teil der den Lichteingang 17 mit dem Lichtausgang 18 verbindenden Seitenfläche des Grundkörpers des Primäroptikelements 5 kann mit einer reflektierenden Schicht (z.B. Al) versehen sein, derart, dass in den Lichteingang 17 eingekoppelte Lichtstrahlen, welche die Bedingung der Totalreflexion an der Seitenfläche nicht erfüllen, dennoch an dieser weitestgehend reflektiert werden. Insbesondere bei dem an den Lichteingang 17 angrenzenden und damit dem Halbleiterchips 3 nächstliegenden Teil der Seitenfläche kann dies zweckmäßig sein.

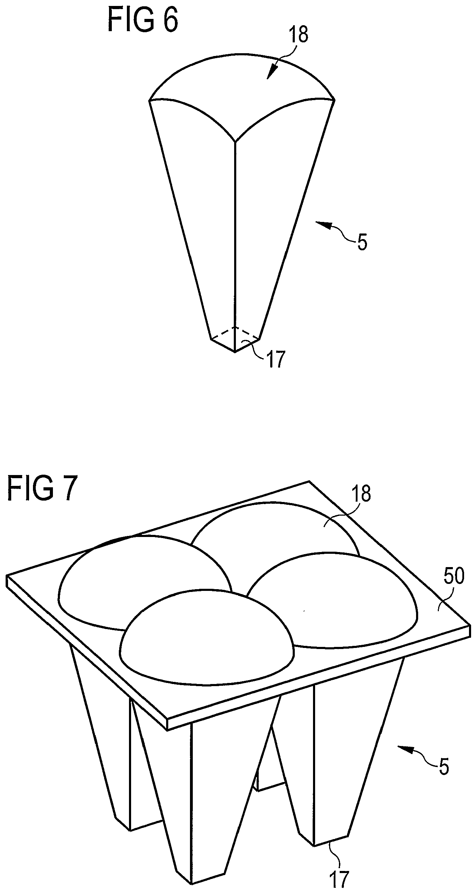

Das in Figur 6 dargestellte Primäroptikelement 5 weist im Unterschied zu den in den Figuren 1 bis 3b dargestellten Primäroptikelementen Seitenwände auf, die in geraden Linien von dem Lichteingang 17 zum Lichtausgang 18 verlaufen. Das Primäroptikelement 5 ist ein dielektrischer Konzentrator mit einer kegelstumpfartigen Grundform, wobei der Lichtausgang 18 nicht eben, sondern in der Art einer asphärischen Linse nach außen gewölbt ist. Verglichen mit einer sphärischen Wölbung nimmt die Wölbung beispielsweise mit zunehmendem Abstand von der optischen Achse des Primäroptikelementes ab, um dem Umstand Rechnung zu tragen, dass der Lichtkegel, dessen Divergenz durch das Primäroptikelement zu verringern ist, keine punktförmige Lichtquelle sondern eine Lichtquelle mit einer gewissen Ausdehnung ist.

Ein Primäroptikelement wie das in Figur 6 dargestellte hat verglichen mit den in den Figuren 1 bis 3b dargestellten Primäroptikelementen 5 den Vorteil, dass mit ihm eine vergleichbare Verringerung der Divergenz eines Lichtkegels bei gleichzeitig signifikanter Verringerung der Bauhöhe des Primäroptikelements 5 erzielt werden kann. Ein weiterer Vorteil des in Figur 6 dargestellten Primäroptikelementes ist, dass dieses aufgrund seiner geraden Seitenflächen einfacher mittels einem Spritzverfahren wie beispielsweise Spritzgießen oder Spritzpressen, hergestellt werden kann.

Der Lichteingang weist z.B. eine Lichteingangsfläche auf, die etwa so groß ist wie eine Chipauskoppelfläche eines mit dem Primäroptikelement zu verwendenden Halbleiterchips. Dadurch kann eine besonders gute Ausnutzung der Divergenz verringernden Eigenschaften des Primäroptikelementes erreicht werden. Besonders bevorzugt ist die Lichteingangsfläche maximal 1,5 mal so groß wie die Chipsauskoppelfläche.

Es ist auch möglich, das Primäroptikelement z.B. mit einem Halbleiterchip zu verwenden, dessen Chipauskoppelfläche größer ist als die Lichteingangsfläche, was jedoch zu einer etwas geringeren Effektivität hinsichtlich emittierter Lichtstärke und Lichtdichte führen kann. Simulationen haben in einem Beispiel ergeben, dass für den Fall einer etwas größeren Chipauskoppelfläche etwa 10 % weniger Lichtintensität in einen Raumwinkel von 15° abgestrahlt werden kann, als bei einer Chipauskoppelfläche, die etwas kleiner ist als die Lichteingangsfläche.

Insbesondere mittels einem Spritzverfahren ist es möglich, mehrere Primäroptikelemente einteilig miteinander auszubilden, wie als Beispiel in Figur 7 dargestellt. Die Primäroptikelemente 5 sind in diesem Ausführungsbeispiel durch eine Trägerplatte 50 miteinander verbunden, wobei die Trägerplatte nahe dem Lichtausgang 18 angeordnet ist, so dass von der einen Seite der Trägerplatte 50 her pyramidenstumpfartige Teile der Primäroptikelemente 5 ausgehen und auf der anderen Seite linsenartige Elemente ausgebildet sind, deren Außenfläche jeweils den Lichtausgang 18 der Primäroptikelemente 5 bildet.

Alternativ zu den anhand der Figuren 6 und 7 erläuterten Ausführungsbeispiele für Primäroptikelemente 5 können diese statt einer pyramidenartigen Grundform beispielsweise auch eine kegelstumpfartige Grundform oder eine Grundform mit einem rechteckigen Querschnitt aufweisen. Es ist ebenso denkbar, dass der quadratische Querschnitt der Primäroptikelemente in den Figuren 6 und 7 zum Lichtausgang 18 hin in eine Querschnittsform übergeht, die mehr als 4 Ecken aufweist, analog zu dem Ausführungsbeispiel, das vorhergehend anhand der Figuren 3a und 3b beschrieben wurde.

Weiterhin ist es möglich, dass das Primäroptikelement derart gestaltet ist, dass eine Divergenz von elektromagnetischer Strahlung in unterschiedlichen, parallel zu einer Hauptabstrahlrichtung des Primäroptikelementes verlaufenden Ebenen unterschiedlich stark verringert wird. Beispielsweise ist der Öffnungswinkel eines emittierten Lichtkegels in einer Ebene etwa 7° und in einer zu dieser Ebene senkrechten Ebene (Schnittfläche entlang einer Hauptabstrahllinie) etwa 10° groß.

Ebenso ist es möglich, dass CPC-, CEC- oder CHC-artige dielektrische Konzentratoren zur weiteren Verringerung der Divergenz eines Lichtkegels ebenfalls einen linsenartig gewölbten Lichtausgang aufweisen. Als Alternative zu einem dielektrischen Konzentrator kann der Konzentrator auch aus einem Hohlkörper mit reflektierenden Innenwänden bestehen, dessen Lichtausgang in Abstrahlrichtung des Konzentrators eine Linse nachgeordnet ist. Beispielsweise ist die Linse auf den Lichtausgang aufgesetzt.

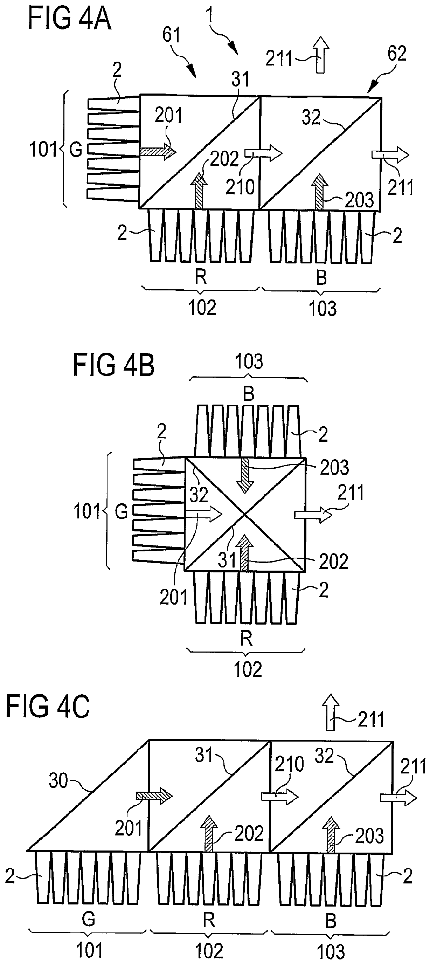

Bei dem in Figur 4a gezeigten Beispiel einer Lichtquelle ist eine Vielzahl von Chip-Primäroptik-Elementen 2 in drei örtlich voneinander getrennten Gruppen 101, 102, 103 angeordnet.
Die Chip-Primäroptik-Elemente 2 können beispielsweise gemäß einem oder mehrerer der oben in Verbindung mit den Figuren 1 bis 3b beschriebenen Beispiele beschaffen sein.
Sie sind in jeder Gruppe 101, 102, 103 matrixartig angeordnet und die Lichtausgänge der Primäroptikelemente 5 schließen weitestgehend lückenlos aneinander an. Auf diese Weise kann ein weitestgehend homogener Lichtkegel emittiert werden, obwohl zwischen den Halbleiterchips relativ große Abstände möglich sind, was bezüglich der Abfuhr der von den Halbleiterchips bei deren Betrieb erzeugten Wärme vorteilhaft ist. Jede der Gruppen 101, 102, 103 weist jeweils Halbleiterchips von nur einer Chipsorte auf. Die erste Gruppe 101 emittiert grünes Licht, die zweite Gruppe 102 rotes Licht und die dritte Gruppe 103 blaues Licht, wie jeweils durch die Buchstaben G, R oder B symbolisiert ist. Von jeder der Gruppen 101, 102, 103 wird jeweils ein separater Lichtkegel emittiert, wie durch Pfeile 201, 202, 203 jeweils angedeutet ist.
Mittels zweier selektiv reflektierender Einheiten 31, 32 werden die separaten Lichtkegel 201, 202, 203 zu einem gemeinsamen Lichtkegel 211 überlagert. Dabei wird zunächst mittels der ersten selektiv reflektierenden Einheit 31 der zweite separate Lichtkegel 202 in den Strahlgang des ersten separaten Lichtkegels 201 gebracht. Die erste selektiv reflektierende Einheit 31 ist für das grüne Licht des ersten separaten Lichtkegels 201 durchlässig und für das rote Licht des zweiten separaren Lichtkegels 202 reflektierend, so dass beide separaten Lichtkegel zu einem Zwischen-Lichtkegel 210 überlagert werden.

Analog wird mittels der zweiten selektiv reflektierende Einheit 32 der dritte separate Lichtkegel 203 mit dem Zwischen-Lichtkegel 210 zu einem gemeinsamen Lichtkegel 211 überlagert. Dabei kann die zweite selektiv reflektierende Einheit 32 entweder für das Licht des Zwischen-Lichtkegels 210 durchlässig und für das Licht des dritten separaten Lichtkegels 103 reflektierend sein oder umgekehrt, so dass für die Lichtquelle 1 zwei verschiedene Lichtausgänge möglich sind.

In dem gemeinsamen Lichtkegel 211 wird weitestgehend homogenes Licht mit einem weitestgehend einheitlichen Farbort in der CIE-Farbtafel abgestrahlt. Dabei ist der Farbort durch die von den Gruppen jeweils emittierte Lichtintensität, d.h. durch die Größe der an den Halbleiterchips verschiedener Gruppen 101, 102, 103 angelegte Betriebsspannung steuerbar. Insbesondere lässt sich so weißes Licht erzeugen, genauso jedoch auch jede beliebige andere Mischfarbe aus den Farben des Lichts der drei separaten Lichtkegel 201, 202, 203.

Die selektiv reflektierenden Einheiten 31, 32 sind z.B. dichroitische Schichtsysteme, d.h. selektiv reflektierende Einheiten, die einen Teil des Spektrums im wesentlichen reflektieren und im übrigen Spektralbereich weitestgehend transmittierend sind. Sie weisen mehrere Lagen unterschiedlich hoch-und niedrigbrechender Materialien auf, die z.B. mittels Sputtern auf Foliensubstrate aufgebracht werden können. Integriert sind die selektiv reflektierenden Einheiten jeweils in einem Zusammenblendwürfel 61, 62 wobei der Lichtausgang des ersten Zusammenblendwürfels 61 direkt an einen Lichteingang des zweiten Zusammenblendwürfels 62 anschließt. Neben den selektiv reflektierenden Einheiten kann der Zusammenblendwürfel aus einem geeigneten, lichtdurchlässigen Material, z.B. einem transparenten Kunststoff wie Polycarbonat bestehen. Alternativ kann der Zusammenblendwürfel auch weggelassen werden, so dass die Sekundäroptik im Wesentlichen aus den selektiv reflektierenden Einheiten und ggf. zugehörigen Trägersystemen besteht.

Im Unterschied zu dem anhand Figur 4a beschriebenen Beispiel weist die in Figur 4b gezeigte Lichtquelle einen Zusammenblendwürfel mit drei Lichteingängen und einem Lichtausgang auf, in den zwei selektiv reflektierende Einheiten 31, 32 integriert sind. Die separaten Lichtkegel 201, 202, 203 werden nach dem gleichen technischen Prinzip wie oben dargelegt mittels der selektiv reflektierenden Einheiten 31, 32 überlagert.
Bei der in Figur 4c veranschaulichten Lichtquelle sind im Unterschied zu den vorgenannten Beispielen alle Chip-Primäroptik-Elemente 2 in einer gemeinsamen Ebene angeordnet, beispielsweise auf einem gemeinsamen Träger (nicht gezeigt). Dadurch kann deren Montage signifikant vereinfacht werden. Der erste separate Lichtkegel 201 wird hierbei mittels eines Spiegel, z.B. eines metallischen Spiegels, in den gewünschten Strahlengang gebracht. Die erste selektiv reflektierende Einheit 31 ist für grünes Licht der Gruppe 101 durchlässig und reflektiert rotes Licht der Gruppe 102. Die zweite selektiv reflektierende Einheit 32 ist für grünes und rotes Licht der Gruppe 101 bzw. 102 durchlässig und für blaues Licht der Gruppe 102 reflektierend.

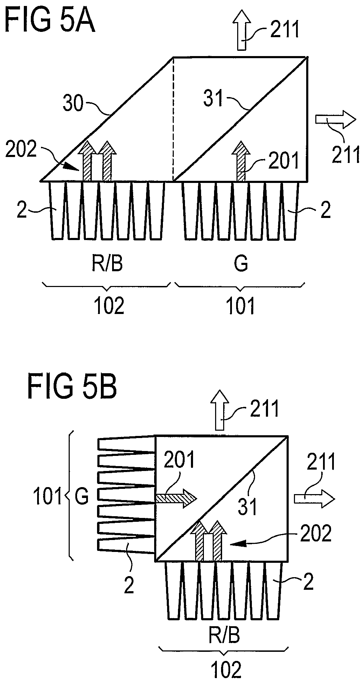

In den Figuren 5a und 5b sind Lichtquellen gezeigt, bei denen die Chips-Primäroptik-Elemente 2 in insgesamt zwei örtlich voneinander getrennten Gruppen 101,102 angeordnet sind. Dabei weist die erste Gruppe 101 nur Halbleiterchips einer Chipsorte auf, die grünes Licht emittiert, symbolisiert durch den Buchstaben G. Die zweite Gruppe 102 weist dagegen Halbleiterchips einer zweiten und einer dritten Chipsorte auf, wobei die zweite Chipsorte rotes Licht und die dritte blaues Licht emittiert, symbolisisert durch die Buchstabenkombination R/B.

Die Halbleiterchips unterschiedlicher Chipsorten der zweiten Gruppe 102 sind gleichmäßig miteinander durchmischt angeordnet, so daß deren Strahlung in deren separaten Lichtkegel 102 zumindest teilweise bereits durchmischt ist.

Wenn aus gesättigtem grünen, roten und blauen Licht weißes Licht erzeugt werden soll, so benötigt man von der gesamten Lichtintensität etwa 65 % an grünem Licht, etwa 28 % an rotem Licht und.etwa 7 % an blauem Licht. Berücksichtigt man zudem typische Werte der Lichtintensität entsprechender verschiedenfarbiger Leuchtdiodenchips, so benötigt man mehr als 50 % grün-emittierende Halbleiterchips.

Dieser Verteilung entspricht die Anzahl von Halbleiterchips unterschiedlicher Chipsorten in den in Figuren 5a und 5b gezeigten Lichtquellen. Demnach kann mit diesen Lichtquellen weißes Licht erzeugt werden, wenn beispielweise die Halbleiterchips alle ungefähr mit ihrer maximalen Leistung betrieben werden. Dies kann auch bei den anhand den Figuren 4a bis 4c erläuterten Ausführungsbeispielen der Fall sein, wenn man die Anzahl von Halbleiterchips der jeweiligen Chipsorte entsprechend anpasst.

Die Lichtquelle ist insbesondere für Projektionssysteme, beispielsweise zum Projezieren von veränderlichen Bildern, geeignet, da mit ihr beispielsweise die Ecken eines typischerweise rechteckigen oder quadratischen Querschnitts besser ausgeleuchtet werden können als mit herkömmlichen Lichtquellen, bei denen zudem in der Regel die Verwendung zusätzlicher Blenden erforderlich ist.

Die obige Erläuterung der Erfindung anhand der Ausführungsbeispiele ist nicht als eine Beschränkung der Erfindung auf diese zu verstehen. So entspricht es etwa auch dem Wesen der Erfindung, wenn einem Primäroptikelement mehrere Halbleiterchips zugeordnet sind. Die Erfindung umfasst auch die Möglichkeit, dass die Lichtquelle mindestens eine Kondensorlinse aufweist, mittels der die Divergenz des gemeinsamen Lichtkegels oder eines oder mehrerer separater Lichtkegel verringert wird. Ebenso umfasst sie, dass jedem Halbleiterchip in Abstrahlrichtung neben dem Primärotptikelement ein weiteres Optikelement nachgeordnet ist, beispielsweise zur Verringerung der Divergenz einer vom Halbleiterchip emittierten Strahlung. Es sei angemerkt, dass ein wesentlicher Aspekt der Erfindung auf der Verwendung eines Konzentrators in umgekehrter Richtung beruht, um die Divergenz der Strahlung von Leuchtdiodenchips zu verringern.

Die Lichtquelle eignet sich, wie oben erwähnt, vorzugsweise für die Verwendung von sichtbares Licht aussendenen Halbleiterchips. Denkbar ist grundsätzlich jedoch auch die Verwendung von Infrarot- oder UV-emittierenden Halbleiterchips. In diesen Fällen wird mittels Leuchtstoffen sichtbare Strahlung erzeugt, die dann mittels selektiv reflektierender Einheiten zu den gewünschten Lichtkegeln überlagert wird.

Alternativ zu den selektiv reflektierenden Einheiten können auch andere Einrichtungen, wie etwa Prismen, zur Überlagerung der separaten Lichtkegel verwendet werden.

Zudem umfasst die Erfindung jedes neue Merkmal und jede Kombination von Merkmalen der Ausführungsbeispiele und der Ansprüche, auch wenn solche Kombinationen nicht explizit in den Ansprüchen oder Ausführungsbeispielen angegeben sind.

## Patentansprüche

1. Lichtquelle mit
- einer Vielzahl von elektromagnetische Strahlung emittierenden Halbleiterchips (3), die eine erste, eine zweite und eine dritte Chipsorte aufweist, deren Emissionsspektren derart sind, dass sich durch Überlagerung der von Halbleiterchips (3) unterschiedlicher Chipsorten emittierten Strahlung weißes Licht erzeugen lässt, wobei jeder Halbleiterchip (3) eine Chipauskoppelfläche (4) aufweist, durch die Strahlung ausgekoppelt wird, und
- einer Vielzahl von Primäroptikelementen (5), wobei jedem Halbleiterchip (3) ein Primäroptikelement (5) zugeordnet ist, das einen Lichteingang (17) und einen Lichtausgang (18) aufweist und durch das die Divergenz zumindest eines Teils der von dem Halbleiterchip (3) bei dessen Betrieb emittierten Strahlung verringert wird,
wobei
- die Halbleiterchips (3) mit den Primäroptikelementen (5) in mindestens zwei örtlich voneinander getrennten Gruppen (101, 102) angeordnet sind, so dass die Gruppen (101, 102) bei Betrieb der Halbleiterchips (3) separate Lichtkegel (201, 202) aussenden und
- die separaten Lichtkegel (201, 202) der Gruppen (101, 102) mittels einer Sekundäroptik zu einem gemeinsamen Lichtkegel (210) überlagert werden,
**dadurch gekennzeichnet, dass**
die Halbleiterchips (3) der ersten Chipsorte in einer ersten Gruppe (101) und die Halbleiterchips (3) der zweiten und dritten Chipsorte in einer zweiten Gruppe (102) angeordnet sind, wobei die Halbleiterchips (3) unterschiedlicher Chipsorten der zweiten Gruppe (102) miteinander durchmischt angeordnet sind.

2. Lichtquelle nach Anspruch 1,
**dadurch gekennzeichnet, dass**
die separaten Lichtkegel (201, 202) der Gruppen (101, 102) mittels der Sekundäroptik zu einem gemeinsamen Lichtkegel (210) mit einem gemeinsamen Farbort überlagert werden.

3. Lichtquelle nach Anspruch 2,
**dadurch gekennzeichnet, dass**
der Farbort des gemeinsamen Lichtkegels (210) im Weißbereich der CIE-Farbtafel liegt.

4. Lichtquelle nach Anspruch 1,
**dadurch gekennzeichnet, dass**
die erste Chipsorte grüne Strahlung, die zweite Chipsorte rote Strahlung und die dritte Chipsorte blaue Strahlung emittiert.

5. Lichtquelle nach einem der Ansprüche 1 bis 4, **dadurch gekennzeichnet, dass**
die Sekundäroptik mindestens eine selektiv reflektierende Einheit (31) aufweist, die für die Strahlung mindestens eines separaten Lichtkegels (201, 202) durchlässig ist und für die Strahlung eines weiteren separaten Lichtkegels (201, 202) reflektierend ist und mittels der mindestens zwei separate Lichtkegel (201, 202) überlagert werden.

6. Lichtquelle nach Anspruch 5, **dadurch gekennzeichnet, dass**
die selektiv reflektierende Einheit (31) ein dichroitisches Schichtsystem enthält.

7. Lichtquelle nach Anspruch 5 oder 6, **dadurch gekennzeichnet, dass**
die Sekundäroptik mindestens einen Zusammenblendwürfel (61) aufweist, der auf mindestens einer selektiv reflektierenden Einheit (31) basiert.

8. Lichtquelle nach einem der Ansprüche 1 bis 7, **dadurch gekennzeichnet, dass**
ein Öffnungswinkel der separaten Lichtkegel (201, 202) zwischen 0 und 60°, bevorzugt zwischen 0 und 40°, besonders bevorzugt zwischen 0 und 20° groß ist, wobei die Grenzen jeweils einbezogen sind.

9. Lichtquelle nach einem der Ansprüche 1 bis 8, **dadurch gekennzeichnet, dass**
die Primäroptikelemente (5) mindestens einer Gruppe (101, 102) zumindest teilweise derart angeordnet sind, dass ihre Lichtausgänge (18) dicht gepackt sind, bevorzugt lückenlos aneinander anschließen.

10. Lichtquelle nach einem der Ansprüche 1 bis 9, **dadurch gekennzeichnet, dass**
die Halbleiterchips (3) mit den Primäroptikelementen (5) im wesentlichen in einer gemeinsamen Ebene angeordnet sind.

11. Lichtquelle nach einem der Ansprüche 1 bis 10, **dadurch gekennzeichnet, dass**
die Halbleiterchips (3) mit den Primäroptikelementen (5) zumindest teilweise oder in Teilgruppen matrixartig angeordnet sind.

12. Lichtquelle nach einem der Ansprüche 1 bis 11, **dadurch gekennzeichnet, dass**
der Lichteingang (17) eine Lichteingangsfläche oder eine Lichteingangsöffnung aufweist, deren Größe kleiner als oder gleich 2 mal die Chipauskoppelfläche (4), bevorzugt kleiner als oder gleich 1,5 mal die Chipauskoppelfläche (4) ist.

13. Lichtquelle nach einem der Ansprüche 1 bis 12, **dadurch gekennzeichnet, dass**
das Primäroptikelement (5) jeweils ein optischer Konzentrator ist, wobei der Lichteingang (17) der eigentliche Konzentratorausgang ist, so dass Licht verglichen mit der üblichen Anwendung eines Konzentrators zum Fokussieren in umgekehrter Richtung durch diesen läuft und somit nicht konzentriert wird, sondern den Konzentrator mit verringerter Divergenz durch den Lichtausgang (18) verlässt.

14. Lichtquelle nach Anspruch 13, **dadurch gekennzeichnet, dass**
der optische Konzentrator ein CPC-, CEC- oder CHC-artiger Konzentrator ist.

15. Lichtquelle nach Anspruch 13, **dadurch gekennzeichnet, dass**
der Konzentrator den Lichteingang (17) mit dem Lichtausgang (18) verbindende Seitenwände aufweist, die derart ausgebildet sind, dass auf den Seitenwänden verlaufende direkte Verbindungslinien zwischen dem Lichtein- und dem Lichtausgang (17, 18) im wesentlichen gerade verlaufen.

16. Lichtquelle nach einem der Ansprüche 13 bis 15, **dadurch gekennzeichnet, dass**
der Konzentrator in einem Bereich auf der Seite des Lichteingangs (17) eine Querschnittsfläche in Form eines regelmäßigen Vielecks, bevorzugt eine quadratische Querschnittsfläche aufweist und dass er in einem Bereich auf der Seite des Lichtausgangs (18) ebenfalls eine Querschnittsfläche in Form eines regelmäßigen Vielecks, bevorzugt eine drei-, vier-, sechs- oder achteckige Querschnittsfläche aufweist.

17. Lichtquelle nach einem der Ansprüche 13 bis 16, **dadurch gekennzeichnet, dass**
der Konzentrator einen einen Hohlraum definierenden Grundkörper aufweist, dessen Innenwand für ein von dem Halbleiterchip (3) ausgesandtes Licht reflektierend ist und/oder dessen Innenwand im Wesentlichen mit einer Schicht oder Schichtenfolge, bevorzugt mit einer metallischen Schicht versehen ist, die für ein von dem Halbleiterchip (3) ausgesandtes Licht reflektierend ist.

18. Lichtquelle nach einem der Ansprüche 13 bis 16, **dadurch gekennzeichnet, dass**
der Konzentrator ein dieelektrischer Konzentrator ist, dessen Grundkörper ein aus einem dieelektrischen Material mit geeignetem Brechungsindex bestehender Vollkörper ist, so dass über den Lichteingang (17) eingekoppeltes Licht in diesem durch Totalreflexion an der den Lichteingang (17) mit dem Lichtausgang (18) verbindenden seitlichen Grenzfläche des Vollkörpers zum umgebenden Medium reflektiert wird.

19. Lichtquelle nach Anspruch 18, **dadurch gekennzeichnet, dass**
der Lichtausgang (18) eine linsenartig gewölbte Grenzfläche des Vollkörpers ist.

20. Lichtquelle nach Anspruch 19, **dadurch gekennzeichnet, dass**
der Lichtausgang (18) in der Art einer asphärischen Linse gewölbt ist.

21. Lichtquelle nach einem der Ansprüche 18 bis 20, **dadurch gekennzeichnet, dass**
der dielektrische Konzentrator zumindest teilweise mit einer Schicht oder Schichtenfolge, bevorzugt mit einer metallischen Schicht versehen ist, die für von dem jeweiligen Halbleiterchip (3) ausgesandtes Licht reflektierend ist.

22. Lichtquelle nach einem der Ansprüche 13 bis 21, **dadurch gekennzeichnet, dass**
der Konzentrator dem Halbleiterchip (3) in dessen Hauptabstrahlrichtung nachgeordnet ist und dass zwischen der Chipauskoppelfläche (4) und dem Lichteingang (17) des Konzentrators ein Spalt (19) besteht.

23. Lichtquelle nach Anspruch 22, **dadurch gekennzeichnet, dass**
der Spalt (19) weitestgehend frei von fester oder viskoser Materie ist.

24. Lichtquelle nach Anspruch 22 oder 23, **dadurch gekennzeichnet, dass**
jedem Halbleiterchip (3) ein oder mehrere Reflektorelemente zugeordnet sind, die derart angeordnet und/oder von solcher Form sind, dass ein Teil der Lichtstrahlen, die nicht direkt vom Halbleiterchip (3) in den Konzentrator gelangen, an diesen mehrfach reflektiert werden und mit einem geringeren Winkel zur Hauptabstrahlrichtung des Halbleiterchips (3) auf den Lichteingang (17) des Konzentrators gelenkt werden.

25. Lichtquelle nach einem der Ansprüche 14 bis 24, **dadurch gekennzeichnet, dass**
der Grundkörper des Konzentrators aus einem transparenten Glas, einem transparenten Kristall oder einem transparenten Kunststoff besteht und dass er bevorzugt in einem Spritzpress- und/oder einem Spritzgußverfahren gefertigt ist.

26. Lichtquelle nach einem der Ansprüche 1 bis 25, **dadurch gekennzeichnet, dass**
der Halbleiterchip (3) eine elektromagnetische Strahlung emittierende Diode, bevorzugt eine elektromagnetische Strahlung emittierende Diode mit zumindest näherungsweise lambertscher Abstrahlcharakteristik, besonders bevorzugt eine Dünnfilm-Leuchtdiode ist.

27. Lichtquelle nach einem der Ansprüche 1 bis 26, **dadurch gekennzeichnet, dass**
die Halbleiterchips (3) auf je einem Träger (12, 15) angeordnet sind, auf dem sie jeweils von einem Rahmen (13) umgeben sind, an oder in dem das Primäroptikelement (5) angebracht ist und von dem dieses gehalten wird und/oder durch das dieses relativ zur Chipauskoppelfläche (4) justiert ist.

28. Lichtquelle nach Anspruch 27, **dadurch gekennzeichnet, dass**
zumindest einige der Träger (12, 15) und/oder jeweils der Träger (12, 15) und der Rahmen (13) einteilig ausgebildet sind.

29. Lichtquelle nach einem der Ansprüche 27 und 28, **dadurch gekennzeichnet, dass**
die Innenfläche des Rahmens (13) und/oder freie Flächen der zur Abstrahlrichtung des Halbleiterchips gewandten Oberfläche des Trägers (12, 15)
- für von dem jeweiligen Halbleiterchip (3) ausgesandtes Licht reflektierend ist bzw. sind und/oder
- zumindest teilweise mit einer Schicht oder Schichtenfolge, bevorzugt mit einer metallischen Schicht versehen ist bzw. sind, die für von dem jeweiligen Halbleiterchip (3) ausgesandtes Licht reflektierend ist.

30. Lichtquelle nach einem der Ansprüche 1 bis 29, **dadurch gekennzeichnet, dass**
mehrere Primäroptikelemente (5) einteilig miteinander ausgebildet sind.

## Claims

1. Light source having
- a multiplicity of electromagnetic-radiation-emitting semiconductor chips (3) have a first, a second, and a third chip type, the emission spectra of which are such that white light can be generated by superposition of the radiation emitted by semiconductor chips (3) of different chip types, wherein each semiconductor chip (3) has a chip coupling-out area (4) through which radiation is coupled out, and
- a multiplicity of primary optical elements (5), wherein each semiconductor chip (3) being assigned a primary optical element (5), which in each case has a light input (17) and a light output (18) and reduces the divergence of at least part of the radiation emitted by the semiconductor chip (3) during the operation thereof,
wherein
- the semiconductor chips (3) with the primary optical elements (5) are arranged in at least two groups (101, 102) that are spatially separate from one another, with the result that the groups (101, 102) emit separate light cones (201, 202) during operation of the semiconductor chips (3), and
- the separate light cones (201, 202) of the groups (101, 102) are superposed by means of a secondary optical arrangement (210) to form a common light cone,
**characterized in that**
- the semiconductor chips (3) of the first chip type are arranged in a first group (101) and the semiconductor chips (3) of the second and third type of chip are arranged in a second group (102), wherein the semiconductor chips (3) of different chip types of the second group (102) are arranged mixed with one another.

2. Light source according to Claim 1,
**characterized in that**
the separate light cones (201, 202) of the groups (101, 102) are superposed by means of the secondary optical arrangement to form a common light cone (210) with a common colour locus.

3. Light source according to Claim 2,
**characterized in that**
the colour locus of the common light cone (210) lies in the white region of the CIE chromaticity diagram.

4. Light source according to Claim 1,
**characterized in that**
the first chip type emits green radiation, the second chip type emits red radiation and the third chip type emits blue radiation.

5. Light source according to any one of Claims 1 to 4,
**characterized in that**
the secondary optical arrangement has at least one selectively reflective unit (31), which is transmissive to the radiation of at least one of the separate light cones (201, 202) and is reflective to the radiation of another of the separate light cones (201, 202) and by means of which at least two separate light cones (201, 202) are superposed.

6. Light source according to Claim 5,
**characterized in that**
the selectively reflective unit (31) contains a dichroic layer system.

7. Light source according to Claim 5 or 6,
**characterized in that**
the secondary optical arrangement has at least one combining cube (61) based on at least one selectively reflective unit (31) .

8. Light source according to any one of Claims 1 to 7,
**characterized in that**
an aperture angle of the separate light cones (201, 202) is between 0 and 60°, preferably between 0 and 40°, particularly preferably between 0 and 20°, wherein the limits being included in each case.

9. Light source according to any one of Claims 1 to 8,
**characterized in that**
the primary optical elements (5) of at least one group (101, 102) are at least partly arranged in such a way that their light outputs (18) are densely packed, and preferably adjoin one another without any gaps.

10. Light source according to any one of Claims 1 to 9,
**characterized in that**
the semiconductor chips (3) with the primary optical elements (5) are essentially arranged in a common plane.

11. Light source according to any one of Claims 1 to 10,
**characterized in that**
the semiconductor chips (3) with the primary optical elements (5) are arranged in matrix-like fashion at least partly or in partial groups.

12. Light source according to any one of Claims 1 to 11,
**characterized in that**
the light input (17) has a light input area or a light input opening, the size of which is less than or equal to 2 times the chip coupling-out area (4), preferably less than or equal to 1.5 times the chip coupling-out area (4).

13. Light source according to any one of Claims 1 to 12,
**characterized in that**
the primary optical element (5) is in each case an optical concentrator, the light input (17) being the actual concentrator output, so that light passes through the concentrator in the opposite direction compared with the customary application of a concentrator for focusing and is thus not concentrated, but rather leaves the concentrator with reduced divergence through the light output (18).

14. Light source according to Claim 13,
**characterized in that**
the optical concentrator is a CPC-, CEC- or CHC-like concentrator.

15. Light source according to Claim 13,
**characterized in that**
the concentrator has side walls which connect the light input (17) to the light output (18) and are formed in such a way that direct connecting lines running on the side walls essentially run straight between the light input (17) and the light output (18).

16. Light source according to any one of Claims 13 to 15,
**characterized in that**
the concentrator has a cross-sectional area in the form of a regular polygon, preferably a square cross-sectional area, in a region on the side of the light input (17), and **in that** it likewise has a cross-sectional area in the form of a regular polygon, preferably a triangular, quadrangular, hexagonal or octagonal cross-sectional area, in a region on the side of the light output (18).

17. Light source according to any one of Claims 13 to 16,
**characterized in that**
the concentrator has a basic body defining a cavity, the inner wall of which basic body is reflective to a light emitted by the semiconductor chip (3), and/or the inner wall of which basic body is essentially provided with a layer or layer sequence, preferably with a metallic layer, which is reflective to a light emitted by the semiconductor chip (3).

18. Light source according to any one of Claims 13 to 16,
**characterized in that**
the concentrator is a dielectric concentrator, the basic body of which is a solid body composed of a dielectric material with a suitable refractive index, so that light coupled in via the light input (17) is reflected in it by total reflection at the lateral interface - connecting the light input (17) to the light output (18) - of the solid body to the surrounding medium.

19. Light source according to Claim 18,
**characterized in that**
the light output (18) is surface of the solid body which is curved in lens-like fashion.

20. Light source according to Claim 19,
**characterized in that**
the light output (18) is curved like an aspherical lens.

21. Light source according to any one of Claims 18 to 20,
**characterized in that**
the dielectric concentrator is at least partly provided with a layer or layer sequence, preferably with a metallic layer, which is reflective to light emitted by the respective semiconductor chip (3).

22. Light source according to any one of Claims 13 to 21,
**characterized in that**
the concentrator is arranged downstream of the semiconductor chip (3) in the main radiating direction thereof, and **in that** there is a gap (19) between the chip coupling-out area (1) and the light input (17) of the concentrator.

23. Light source according to Claim 22,
**characterized in that**
the gap (19) is substantially free of solid or viscous material.

24. Light source according to Claim 22 or 23,
**characterized in that**
each semiconductor chip (3) is assigned one or more reflector elements, which are arranged and/or are of a form such that some of the light beams which do not pass directly from the semiconductor chip (3) into the concentrator are multiply reflected at said reflector elements and directed onto the light input (17) of the concentrator at a smaller angle with respect to the main radiating direction of the semiconductor chip (3).

25. Light source according to any one of Claims 14 to 24,
**characterized in that**
the basic body of the concentrator comprises a transparent glass, a transparent crystal or a transparent plastic, and **in that** it is preferably produced in a transfer moulding method and/or an injection moulding method.

26. Light source according to any one of Claims 1 to 25,
**characterized in that**
the semiconductor chip (3) is an electromagnetic-radiation-emitting diode, preferably an electromagnetic-radiation-emitting diode with a radiating characteristic which complies at least approximately with Lambert's law, particularly preferably a thin-film light-emitting diode.

27. Light source according to any one of Claims 1 to 26,
**characterized in that**
the semiconductor chips (3) are arranged on a respective carrier (12, 15) on which they are in each case surrounded by a frame (13) at or in which the primary optical element (5) is fitted and by which the latter is held and/or by which the latter is adjusted relative to the chip coupling-out area (4) .

28. Light source according to Claim 27,
**characterized in that**
at least some of the carriers (12, 15) and/or in each case the carrier (12, 15) and the frame (13) are formed in one part with one another.

29. Light source according to any one of Claims 27 and 28,
**characterized in that**
the inner area of the frame (13) and/or free areas of that surface of the carrier (12, 15) which faces towards the radiating direction of the semiconductor chip
- is or are reflective to light emitted by the respective semiconductor chip (3) and/or
- is or are at least partly provided with a layer or layer sequence, preferably with a metallic layer, which is reflective to light emitted by the respective semiconductor chip (3).

30. Light source according to any one of Claims 1 to 29,
**characterized in that**
a plurality of primary optical elements (5) are formed in one part with one another.

## Revendications

1. Source de lumière, comprenant
- une pluralité de puces en semiconducteur (3) émettant un rayonnement électromagnétique, laquelle présente une première, une deuxième et une troisième sorte de puce dont les spectres d'émission sont tels que la superposition du rayonnement émis par les puces en semiconducteur (3) des différentes sortes de puce permet de générer de la lumière blanche, chaque puce en semiconducteur (3) possédant une surface de sortie de puce (4) à travers laquelle sort le rayonnement, et
- une pluralité d'éléments optiques primaires (5), un élément optique primaire (5) étant associé à chaque puce en semiconducteur (3), lequel possède une entrée de lumière (17) et une sortie de lumière (18) et par le biais duquel est réduite la divergence d'au moins une partie du rayonnement émis par la puce en semiconducteur (3) lors de son fonctionnement,
- les puces en semiconducteur (3) avec les éléments optiques primaires (5) étant arrangées en au moins deux groupes (101, 102) séparés localement les uns des autres, de sorte que les groupes (101, 102) émettent des cônes lumineux (201, 202) séparés lors du fonctionnement des puces en semiconducteur (3), et
- les cônes lumineux (201, 202) séparés des groupes (101, 102) étant superposés en un cône lumineux commun (210) au moyen d'une optique secondaire,
**caractérisée en ce que**
les puces en semiconducteur (3) de la première sorte de puce sont arrangées dans un premier groupe (101) et les puces en semiconducteur (3) des deuxième et troisième sortes de puce dans un deuxième groupe (102), les puces en semiconducteur (3) des différentes sortes de puce du deuxième groupe (102) étant arrangées mélangées entre elles.

2. Source de lumière selon la revendication 1, **caractérisée en ce que** les cônes lumineux (201, 202) séparés des groupes (101, 102) sont superposés au moyen de l'optique secondaire en un cône lumineux commun (210) ayant une localisation chromatique commune.

3. Source de lumière selon la revendication 2, **caractérisée en ce que** la localisation chromatique du cône lumineux commun (210) se trouve dans la plage blanche du nuancier CIE.

4. Source de lumière selon la revendication 1, **caractérisée en ce que** la première sorte de puce émet un rayonnement vert, la deuxième sorte de puce un rayonnement rouge et la troisième sorte de puce un rayonnement bleu.

5. Source de lumière selon l'une des revendications 1 à 4, **caractérisée en ce que** l'optique secondaire possède au moins une unité à réflectivité sélective (31), laquelle est transparente pour le rayonnement d'au moins un cône lumineux (201, 202) séparé et réfléchissante pour le rayonnement d'au moins un autre cône lumineux (201, 202) séparé et au moyen de laquelle au moins deux cônes lumineux (201, 202) séparés sont superposés.

6. Source de lumière selon la revendication 5, **caractérisée en ce que** l'unité à réflectivité sélective (31) contient un système de couche dichroïque.

7. Source de lumière selon la revendication 5 ou 6, **caractérisée en ce que** l'optique secondaire possède au moins un cube combineur de rayons (61) qui se base sur au moins une unité à réflectivité sélective (31).

8. Source de lumière selon l'une des revendications 1 à 7, **caractérisée en ce qu'**un angle d'ouverture des cônes lumineux (201, 202) séparés est compris entre 0 et 60°, de préférence entre 0 et 40°, notamment de préférence entre 0 et 20°, les limites étant respectivement incluses.

9. Source de lumière selon l'une des revendications 1 à 8, **caractérisée en ce que** les éléments optiques primaires (5) d'au moins un groupe (101, 102) sont au moins partiellement arrangés de telle sorte que leurs sorties de lumière (18) sont condensées densément, de préférence adjointes l'une contre l'autre sans interruption.

10. Source de lumière selon l'une des revendications 1 à 9, **caractérisée en ce que** les puces en semiconducteur (3) avec les éléments optiques primaires (5) sont disposées sensiblement dans un plan commun.

11. Source de lumière selon l'une des revendications 1 à 10, **caractérisée en ce que** les puces en semiconducteur (3) avec les éléments optiques primaires (5) sont disposées au moins partiellement ou en groupes partiels à la manière d'une matrice.

12. Source de lumière selon l'une des revendications 1 à 11, **caractérisée en ce que** l'entrée de lumière (17) possède une surface d'entrée de lumière ou une ouverture d'entrée de lumière dont la taille est inférieure ou égale à 2 fois la surface de sortie de puce (4), de préférence inférieure ou égale à 1,5 fois la surface de sortie de puce (4).

13. Source de lumière selon l'une des revendications 1 à 12, **caractérisée en ce que** l'élément optique primaire (5) est respectivement un concentrateur optique, l'entrée de lumière (17) étant la sortie du concentrateur proprement dite, de sorte que la lumière, en comparaison de l'application habituelle d'un concentrateur pour la focalisation, passe à travers celui-ci en sens inverse et n'est ainsi pas concentrée, mais quitte le concentrateur à travers la sortie de lumière (18) avec une divergence réduite.

14. Source de lumière selon la revendication 13, **caractérisée en ce que** le concentrateur optique est un concentrateur de type CPC, CEC ou CHC.

15. Source de lumière selon la revendication 13, **caractérisée en ce que** le concentrateur possède des parois latérales qui relient l'entrée de lumière (17) à la sortie de lumière (18), lesquelles sont configurées de telle sorte que les lignes de liaison directes qui s'étendent sur les parois latérales s'étendent sensiblement en ligne droite entre l'entrée et la sortie de lumière (17, 18).

16. Source de lumière selon l'une des revendications 13 à 15, **caractérisée en ce que** le concentrateur, dans une zone sur le côté de l'entrée de lumière (17), présente une surface de section transversale sous la forme d'un polygone régulier, de préférence une surface de section transversale carrée, et **en ce que** dans une zone sur le côté de la sortie de lumière (18), il présente également une surface de section transversale sous la forme d'un polygone régulier, de préférence une surface de section transversale triangulaire, rectangulaire, hexagonale ou octogonale.

17. Source de lumière selon l'une des revendications 13 à 16, **caractérisée en ce que** le concentrateur possède un corps de base qui définit un espace creux dont la paroi intérieure est réfléchissante pour une lumière émise par la puce en semiconducteur (3) et/ou dont la paroi intérieure est sensiblement pourvue d'une couche ou d'une séquence de couche, de préférence d'une couche métallique, qui est réfléchissante pour une lumière émise par la puce en semiconducteur (3).

18. Source de lumière selon l'une des revendications 13 à 16, **caractérisée en ce que** le concentrateur est un concentrateur diélectrique dont le corps de base est un corps plein constitué d'un matériau diélectrique ayant un indice de réfraction approprié, de sorte que la lumière injectée par le biais de l'entrée de lumière (17) est réfléchie dans celui-ci vers le milieu environnant par réflexion totale au niveau de la surface de délimitation latérale du corps plein qui relie l'entrée de lumière (17) à la sortie de lumière (18).

19. Source de lumière selon la revendication 18, **caractérisée en ce que** la sortie de lumière (18) est une surface de délimitation bombée à la manière d'une lentille du corps plein.

20. Source de lumière selon la revendication 19, **caractérisée en ce que** la sortie de lumière (18) est bombée la manière d'une lentille asphérique.

21. Source de lumière selon l'une des revendications 18 à 20, **caractérisée en ce que** le concentrateur diélectrique est pourvu au moins partiellement d'une couche ou d'une séquence de couches, de préférence d'une couche métallique qui est réfléchissante pour la lumière émise par la puce en semiconducteur (3) correspondante.

22. Source de lumière selon l'une des revendications 13 à 21, **caractérisée en ce que** le concentrateur est disposé après la puce en semiconducteur (3) dans le sens de son rayonnement principal et **en ce qu'**il existe une fente (19) entre la surface de sortie de puce (4) et l'entrée de lumière (17) du concentrateur.

23. Source de lumière selon la revendication 22, **caractérisée en ce que** la fente (19) est sensiblement exempte de matière solide ou visqueuse.

24. Source de lumière selon la revendication 22 ou 23, **caractérisée en ce qu'**un ou plusieurs éléments réflecteurs sont associés à chaque puce en semiconducteur (3), lesquels sont disposés et/ou présentent une forme de telle sorte qu'une partie des rayons lumineux qui ne parviennent pas directement de la puce en semiconducteur (3) dans le concentrateur est réfléchie plusieurs fois par ceux-ci et sont déviés sur l'entrée de lumière (17) du concentrateur avec un angle plus faible par rapport au sens du rayonnement principal de la puce en semiconducteur (3).

25. Source de lumière selon l'une des revendications 14 à 24, **caractérisée en ce que** le corps de base du concentrateur se compose d'un verre transparent, d'un cristal transparent ou d'une matière plastique transparente et qu'il est de préférence fabriqué dans un procédé d'injection sous pression et/ou de moulage par injection.

26. Source de lumière selon l'une des revendications 1 à 25, **caractérisée en ce que** la puce en semiconducteur (3) est une diode qui émet un rayonnement électromagnétique, de préférence une diode qui émet un rayonnement électromagnétique ayant au moins approximativement une caractéristique de rayonnement Lambert, de manière particulièrement préférée une diode électroluminescente à film mince.

27. Source de lumière selon l'une des revendications 1 à 26, **caractérisée en ce que** les puces en semiconducteur (3) sont à chaque fois disposées sur un élément porteur (12, 15) sur lequel elles sont respectivement entourées par un cadre (13), sur ou dans lequel est monté l'élément optique primaire (5) et maintenu par celui-ci et/ou par le biais duquel celui-ci est ajusté par rapport à la surface de sortie de puce (4).

28. Source de lumière selon la revendication 27, **caractérisée en ce qu'**au moins certains des éléments porteurs (12, 15) et/ou respectivement les éléments porteurs (12, 15) et les cadres (13) sont réalisés d'une seule pièce.

29. Source de lumière selon l'une des revendications 27 et 28, **caractérisée en ce que** la surface intérieure du cadre (13) et/ou les surfaces libres de la surface de l'élément porteur (12, 15) qui est orientée vers la direction du rayonnement de la puce en semiconducteur
- est réfléchissante, respectivement sont réfléchissantes pour la lumière émise par la puce en semiconducteur (3) et/ou
- est pourvue, respectivement sont pourvues au moins partiellement d'une couche ou d'une séquence de couche, de préférence d'une couche métallique, qui est réfléchissante pour la lumière émise par la puce en semiconducteur (3).

30. Source de lumière selon l'une des revendications 1 à 29, **caractérisée en ce que** plusieurs éléments optiques primaires (5) sont configurés d'une seule pièce les uns avec les autres.
